# EUROPÄISCHE PATENTANMELDUNG

(11) **EP 1 148 647 A2**
(43) Veröffentlichungstag der Anmeldung: **24.10.2001**
(21) Anmeldenummer: 01106847.5
(22) Anmeldetag: 19.03.2001
(51) Int. Cl.: H03K 5/135, H03L 7/081, H03K 5/26

(54) **Schaltungsanordnung zum Empfang von wenigstens zwei digitalen Signalen**

(30) Priorität: 04.04.2000 DE 10016724
(71) Anmelder: Infineon Technologies AG, 81669 München (DE)
(72) Erfinder: Nikutta, Wolfgang, 81541 München (DE)
(74) Vertreter: Epping Hermann & Fischer

(57) **Zusammenfassung**

Eine Schaltungsanordnung (1) weist eine Kalibrierschaltung (2) auf, die mit Anschlüssen (11, 12) für zwei digitale Signale (E1, E2) verbunden ist und die Ausgänge (13, 14) für zwei digitale Ausgangssignale (A1, A2) aufweist, die jeweils aus einem der digitalen Signale (E1, E2) abgeleitet sind. Durch die Kalibrierschaltung (2) erfolgt eine zeitliche Steuerung einer Schaltflanke eines der Ausgangssignale (A1, A2) anhand eines Steuerwertes (R). Mit einer Vergleichsschaltung (3) wird ein Vergleichssignal (V) erzeugt, das anzeigt, daß eines der Ausgangssignale (A1, A2) relativ zum anderen Ausgangssignal zuerst eine Schaltflanke aufweist. Die Kalibrierschaltung (2) weist einen Steuereingang (21) auf, über den der Steuerwert (R), der in einer Speicherschaltung (4) gespeichert ist, anhand des Zustands des Vergleichssignals (V) der Vergleichsschaltung (3) einstellbar ist. Durch die Schaltungsanordnung (1) ist es möglich, nicht erwünschte Laufzeitunterschiede zwischen den digitalen Signalen (E1, E2) auszugleichen.

## Beschreibung

Die vorliegende Erfindung betrifft eine Schaltungsanordnung zum Empfang von wenigstens zwei digitalen Signalen.

Integrierte Schaltungen (ICs), in denen mehrere digitale Signale mit vergleichsweise hohen Schaltgeschwindigkeiten empfangen und verarbeitet werden, erfordern aufgrund einer oftmals zeitlich sehr engen Spezifikation zeitlich sehr genau angepaßte Laufzeiten der Signale, beispielsweise zwischen den verschiedenen Bauelementen auf der Leiterplatte (sogenanntes PCB), auf der die jeweilige integrierte Schaltung aufgebracht ist.

Dazu ist es im allgemeinen erforderlich, insbesondere Leiterbahnlängen und Impedanzen von Bussystemen oder elektrischen Verbindungen innerhalb der IC-Gehäuse sowie Leiterbahnlängen innerhalb von integrierten Schaltungen möglichst exakt einander anzupassen. Dabei ist es zweckmäßig, vorhandene Eingangspuffer-Schaltungen, die in der Regel ebenfalls Signalverzögerungen verursachen, mit einzubeziehen. Eine systematische Fehlanpassung oder vorhandene Fertigungstoleranzen bei der Bemessung von Leitungsparametern können dabei zu reduzierten zeitlichen Sicherheitsabständen zwischen elektrischen Signalen und damit zu einer geringeren Bandbreite des Gesamtsystems führen. Zusätzlich können durch das Erfordernis der Einhaltung geringer Toleranzen in einer Fertigung erhebliche Kosten beispielsweise durch Messungen, Kontrollen und Verwurf verursacht werden.

In digitalen synchronen Schaltungen sind üblicherweise die sogenannten Timing-Spezifikationen auf ein Taktsignal bezogen, teilweise auch auf mehrere Taktsignale wie z.B. sogenannte Transmit bzw. Receive Clocks oder auch differentielle Taktsignale. Vorhandene individuelle Laufzeit-Streuungen auf Signalleitungen, wie z.B. Adressleitungen oder Daten- und Steuerleitungen, relativ zu diesem Referenz-Takt engen den sicheren Arbeitsbereich und damit die maximal erreichbare Geschwindigkeit des Systems ein.

Die Aufgabe der vorliegenden Erfindung ist es, eine Schaltungsanordnung zum Empfang von wenigstens zwei digitalen Signalen anzugeben, mit der zwei digitale Signale ohne zeitliche Einschränkungen weiterverarbeitet werden können, so daß eine aufwendige Anpassung von Leitungsparametern und Fertigungstoleranzen nicht erforderlich ist.

Die Aufgabe wird gelöst durch eine Schaltungsanordnung zum Empfang von wenigstens zwei digitalen Signalen mit einer Kalibrierschaltung, die mit Anschlüssen für wenigstens zwei digitale Signale verbunden ist und die Ausgänge für wenigstens zwei digitale Ausgangssignale aufweist, die jeweils aus einem der digitalen Signale abgeleitet sind, bei der durch die Kalibrierschaltung eine zeitliche Steuerung einer Schaltflanke eines der Ausgangssignale anhand eines Steuerwertes erfolgt, mit einer Vergleichsschaltung, die mit den Ausgängen verbunden ist und die einen Anschluß für ein Vergleichssignal aufweist, das anzeigt, daß eines der Ausgangssignale relativ zum anderen Ausgangssignal zuerst eine Schaltflanke aufweist, bei der die Kalibrierschaltung eine Speicherschaltung enthält zur Speicherung des Steuerwertes, und bei der die Kalibrierschaltung einen Steuereingang aufweist, über den der Steuerwert anhand des Zustands des Vergleichssignals der Vergleichsschaltung einstellbar ist.

Mit der erfindungsgemäßen Schaltungsanordnung ist es möglich, eines der digitalen Signale bzw. dessen Schaltflanken in Bezug zum anderen digitalen Signal so einzustellen, so daß am Ausgang der Schaltungsanordnung Ausgangssignale mit zeitlich koordinierten Schaltflanken zur Weiterverarbeitung abgreifbar sind. Dadurch können nicht erwünschte Laufzeitunterschiede zwischen den beiden digitalen Signalen kompensiert werden. Das Vergleichssignal der Vergleichsschaltung zeigt dabei mit einem aktiven Zustand an, daß die Schaltflanken der Ausgangssignale zeitlich nicht koordiniert sind. Durch eine entsprechende Steuerung der Kalibrierschaltung kann über den Steuerwert eines der Ausgangssignale bzw. können dessen Schaltflanken so eingestellt werden, bis das Vergleichssignal der Vergleichsschaltung nicht mehr im aktiven Zustand ist. Ist dieser Zustand erreicht, sind die beiden Ausgangssignale, die jeweils aus den digitalen Signalen abgeleitet sind, miteinander synchronisiert. Dabei wird nur der Zeitpunkt der Schaltflanken der digitalen Signale verändert, so daß diese miteinander koordiniert sind. Die digitalen Signale bleiben ansonsten unverändert. Damit können die zwei digitalen Signale ohne zeitliche Einschränkungen weiterverarbeitet werden.

Die beschriebene Kalibrierung der Schaltungsanordnung wird beispielsweise in einem Funktionsmode bzw. einem Testmode durchgeführt. Dabei werden von einer treibenden Schaltung, beispielsweise einem externen Testgerät, die zu kalibrierenden Signale synchron zueinander generiert und beispielsweise über Pufferschaltungen und Busleitungen an eine empfangende Schaltung angelegt, die die erfindungsgemäße Schaltungsanordnung enthält. Der im Testbetrieb eingestellte Steuerwert wird in der Speicherschaltung gespeichert, so daß eine zeitliche Steuerung der Signale anhand des Steuerwertes in einem Normalbetrieb durchgeführt werden kann.

In einer Weiterbildung der Erfindung ist der Anschluß für das Vergleichssignal der Vergleichsschaltung mit dem Steuereingang der Kalibrierschaltung verbunden. Dadurch ist es möglich, daß sich die Schaltungsanordnung bzw. eine integrierte Schaltung, die die Schaltungsanordnung enthält, selbst automatisch kalibriert. Das bedeutet, der Steuerwert der Kalibrierschaltung wird direkt durch den Zustand des Vergleichssignals der Vergleichsschaltung eingestellt.

Der Einstellvorgang wird vorzugsweise durch ein Vergleichssignal der Vergleichsschaltung vorgenommen, das in einem aktiven Zustand einen periodischen Verlauf aufweist. Der Steuerwert ist dadurch digital einstellbar, beispielsweise durch Ansteuerung eines Zählers, der in einer Periode des Vergleichssignals z.B. jeweils um eine Stufe erhöht wird.

Ein Zeitvergleich von Schaltflanken zweier Signale läßt sich verhältnismäßig einfach mit einer bistabilen Kippstufe in Form eines Flip-Flops realisieren. Bei einer Realisierung der Schaltungsanordnung in CMOS-Technologie, die eine Strukturbreite bzw. Kanallängen der Transistoren von weniger als 0,2µm aufweist, läßt sich üblicherweise bei einem symmetrischen Layout der Vergleichsschaltung eine Zeitdifferenz von wenigen Pikosekunden noch sicher detektieren.

Um einen Umschaltzeitpunkt des Vergleichssignals der Vergleichsschaltung vom aktiven Zustand in einen inaktiven Zustand genauer zu detektieren, ist es vorteilhaft, daß dem Anschluß für das Vergleichssignal der Vergleichsschaltung eine Filterschaltung und/oder eine Integratorschaltung nachgeschaltet ist. Das Vergleichssignal geht dabei vom aktiven Zustand in den inaktiven Zustand über oder umgekehrt, wenn beide Ausgangssignale in etwa gleichzeitig auftretende Schaltflanken aufweisen. Aufgrund von statistischen Effekten (z.B. infolge von Signalunschärfen) treten üblicherweise um den Umschaltpunkt herum zeitliche Bereiche auf, in denen aktive und inaktive Vergleichssignale mit etwa gleicher Häufigkeit auftreten. Durch eine nachgeschaltete Filterschaltung und/oder durch eine Integrätorschaltung läßt sich somit ein zu bestimmender Steuerwert (Kalibrierwert) sehr exakt bestimmen.

In einer Weiterbildung der Erfindung weist die Kalibrierschaltung eine Verzögerungsschaltung auf, die ihrerseits einen Eingang aufweist, der mit einem der Anschlüsse für die digitalen Signale verbunden ist zur Einstellung einer Verzögerung einer Schaltflanke eines der digitalen Signale. Dabei ist ein Ausgang der Verzögerungsschaltung mit einem der Ausgänge verbunden. Es werden also vorhandene Laufzeitunterschiede der beiden digitalen Signale dadurch kompensiert, indem eine Schaltflanke eines der Signale zeitlich verzögert wird.

Die Verzögerungsschaltung enthält vorzugsweise digital einstellbare Verzögerungsglieder. Eine einzustellende Verzögerung kann dadurch anhand eines digitalen Steuerwertes, der beispielsweise in einem Register mit mehreren Registerbits gespeichert ist, eingestellt werden. Die Einstellung einer Verzögerung kann daher in Stufen erfolgen, beispielsweise mit einem periodischen Signal, wie oben beschrieben. Die einzelnen Stufen der Verzögerung müssen dabei nicht streng linear sein, da sich die Schaltungsanordnung bzw. die Kalibrierschaltung iterativ einem korrekten Steuerwert annähern kann. Es muß dabei sicher gestellt sein, daß sich die Verzögerung kontinuierlich ändern läßt. Digital einstellbare Verzögerungsglieder können beispielsweise in Form von zuschaltbaren Inverterketten realisiert sein.

In einer weiteren Ausführungsform der Erfindung weist die Verzögerungsschaltung analog einstellbare Verzögerungsglieder auf. Diese können beispielsweise in Form von einstellbaren RC-Verzögerungsgliedern realisiert sein. Es ist grundsätzlich möglich, digital einstellbare Verzögerungsglieder mit analog einstellbaren Verzögerungsgliedern zu kombinieren.

Um sowohl steigende als auch fallende Schaltflanken kalibrieren zu können, sind in einer Weiterbildung der Erfindung die Kalibrierschaltung und die Anschlüsse für die digitalen Signale jeweils über eine Inverterschaltung miteinander koppelbar. Dabei können mit einem Umschalter beide Arten von Schaltflanken unabhängig voneinander kalibriert werden.

Die erfindungsgemäße Schaltungsanordnung kann vergleichsweise einfach in Test- und Meßgeräten integriert werden. Dadurch ist es möglich, Testsignale von beispielsweise Hochgeschwindigkeits-Testgeräten zu synchronisieren, die bisher im allgemeinen mit einem vergleichsweise hohen Kosten- und Zeitaufwand mit Hilfe von sogenannter Sample-Scopes kalibriert werden.

Weitere vorteilhafte Aus- und Weiterbildungen sind Gegenstand abhängiger Ansprüche.

Die Erfindung wird im Folgenden anhand der in der Zeichnung dargestellten Figuren näher erläutert. Es zeigen:
- Figur 1: eine schematische Darstellung von Signalen mit Laufzeitunterschieden,
- Figuren 2 und 3: Ausführungsformen der Erfindung,
- Figuren 4 und 5: Ausführungsformen der Vergleichsschaltung,
- Figur 6: eine schematische Darstellung von Signalen gemäß der Ausführungsform nach Figur 5.

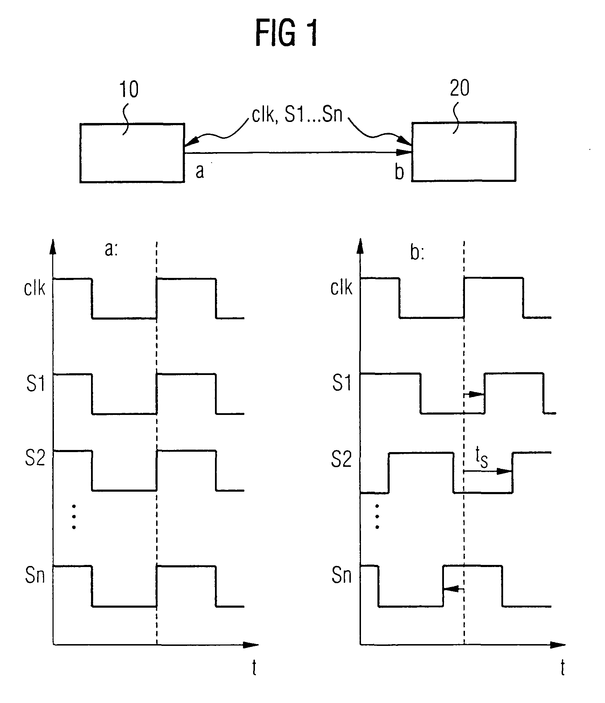

Im oberen Teil der Figur 1 ist eine integrierte Schaltung 10 und eine integrierte Schaltung 20 dargestellt, die über einen Signalbus miteinander verbunden sind. Über diesen Signalbus werden ein Taktsignal clk und Signale S1 bis Sn übertragen. Die integrierte Schaltung 10 befindet sich beispielsweise in einem Testmodus. In diesem werden alle Signale synchron zu dem Taktsignal clk übertragen. Die entsprechenden Signalverläufe sind beispielhaft im unteren Teil der Figur 1 dargestellt.

In dem in Figur 1 dargestellten Beispiel sei angenommen, daß die Signale S1 bis Sn unterschiedliche Signallaufzeiten aufweisen. Das heißt, die Signale S1 bis Sn weisen am Eingang der integrierten Schaltung 20 zeitliche Verschiebungen auf, die als Zeit tₛ gekennzeichnet sind. Diese zeitlichen Verschiebungen werden auch als sogenannte Skews bezeichnet.

Die treibende Schaltung 10 weist einen Funktionsmode bzw. Testmode auf, in dem die Signale S1 bis Sn synchron zum Taktsignal clk generiert werden. Soll eine spätere Kalibrierung der Signale S1 bis Sn durchgeführt werden, so muß bei periodischen Signalen S1 bis Sn die Bedingung t(Periode) > 2 tS erfüllt sein. Nur so ist es möglich, eindeutig festzustellen, ob ein Signal S1 bis Sn in Bezug zum Referenzsignal clk zu schnell oder zu langsam zu der empfangenden Schaltung 20 übertragen wird. Dabei ist es nicht von Belang, wenn die generierten Signale S1 bis Sn bereits bei der treibenden Schaltung 10 gegeneinander verschoben erzeugt werden, so lange dieser Offset auch in einem Normalbetrieb beibehalten wird.

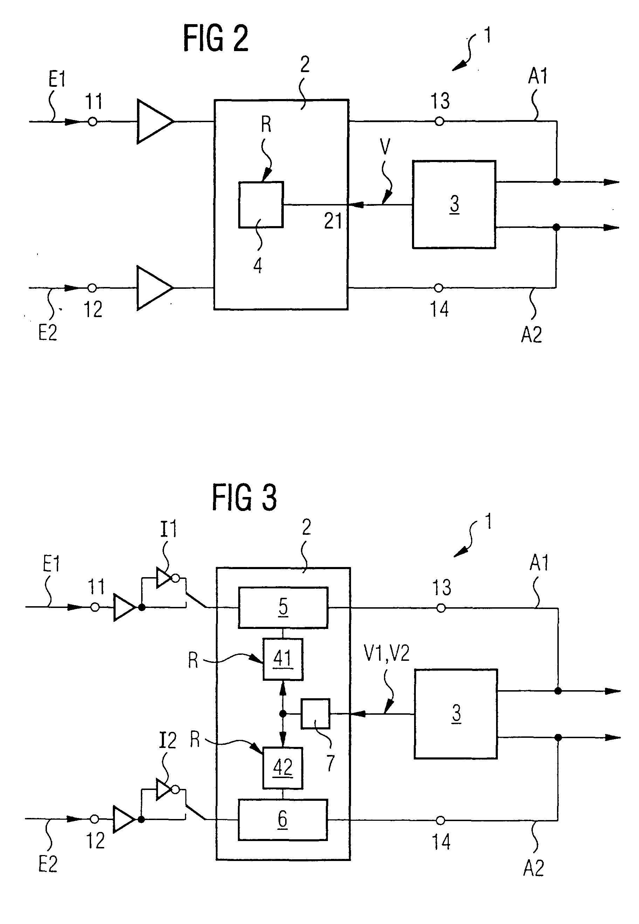

In Figur 2 ist eine Ausführungsform der erfindungsgemäßen Schaltungsanordnung dargestellt, die beispielsweise in der empfangenden Schaltung 20 enthalten ist. Die Schaltungsanordnung 1 weist Anschlüsse 11 und 12 auf für wenigstens zwei digitale Eingangssignale E1 bzw. E2. Das Signal E1 ist beispielsweise das Taktsignal clk aus Figur 1. Das Signal E2 ist beispielsweise einer der Signale S1 bis Sn aus Figur 1. An den Ausgängen 13 und 14 einer Kalibrierschaltung 2 sind zwei digitale Ausgangssignale A1 und A2 zu entnehmen, die jeweils aus einem der Eingangssignale E1 bzw. E2 abgeleitet sind. Die Ausgangssignale A1 und A2 liegen beispielsweise an einer weiteren Schaltung wie z.B. einem Adreß-Latch an. Zwischen die Anschlüsse 11,12 und die Ausgänge 13,14 ist die Kalibrierschaltung 2 geschaltet. Die Kalibrierschaltung 2 ist dabei über jeweils eine Eingangspufferschaltung mit den Anschlüssen 11 bzw. 12 verbunden. Eine Vergleichsschaltung 3 ist mit den Ausgängen 13 und 14 verbunden und weist einen Anschluß für ein Vergleichssignal V auf. Das Vergleichssignal V zeigt mit einem aktiven Zustand an, daß beispielsweise das Ausgangssignal A1 relativ zum Ausgangssignal A2 zuerst eine Schaltflanke aufweist.

In der Ausführungsform nach Figur 2 ist der Anschluß für das Vergleichssignal V der Vergleichsschaltung 3 mit einem Steuereingang 21 der Kalibrierschaltung 2 verbunden. Über den Steuereingang 21 ist ein Steuerwert R anhand des Zustands des Vergleichssignals V einstellbar. Der Steuerwert R wird in der Speicherschaltung 4, die in der Kalibrierschaltung 2 enthalten ist, gespeichert. Anhand des Steuerwertes R kann eine zeitliche Steuerung beispielsweise des Ausgangssignals A2 bzw. eine Steuerung dessen Schaltflanke vorgenommen werden.

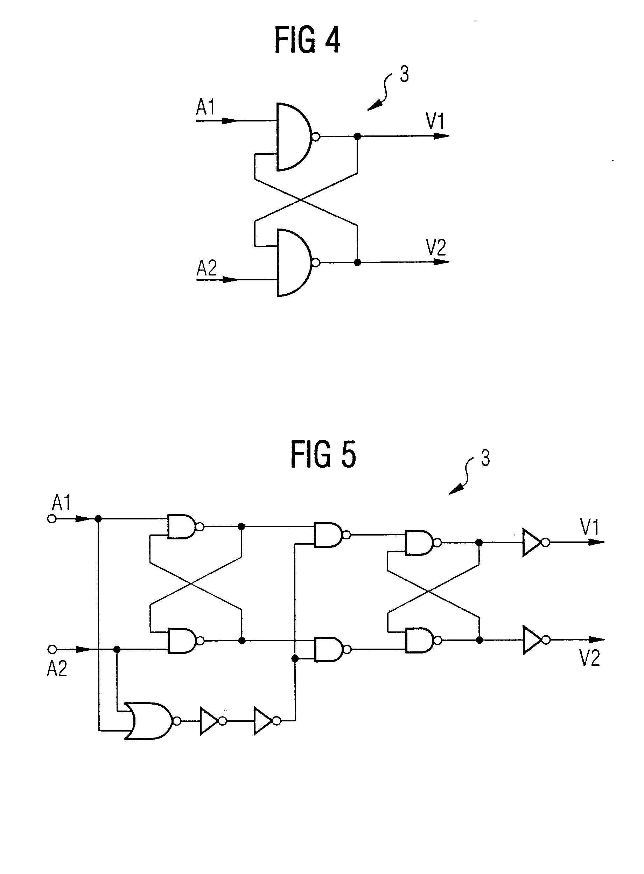

Ein Zeitvergleich zweier steigender Schaltflanken in der Vergleichsschaltung 3 läßt sich dabei relativ einfach mit einer bistabilen Kippstufe in Form eines Flip-Flops gemäß Figur 4 realisieren. Das dargestellte Flip-Flop weist dazu NAND-Gatter auf. Weist das Signal A2 beispielsweise eine steigende Schaltflanke vor dem Signal A1 auf, so weist das Vergleichssignal V2 einen aktiven Zustand auf, das Vergleichssignal V1 weist einen inaktiven Zustand auf. Die Zustände der Vergleichssignale V1 und V2 sind entsprechend invertiert, wenn das Signal A1 eine steigende Schaltflanke vor dem Signal A2 aufweist.

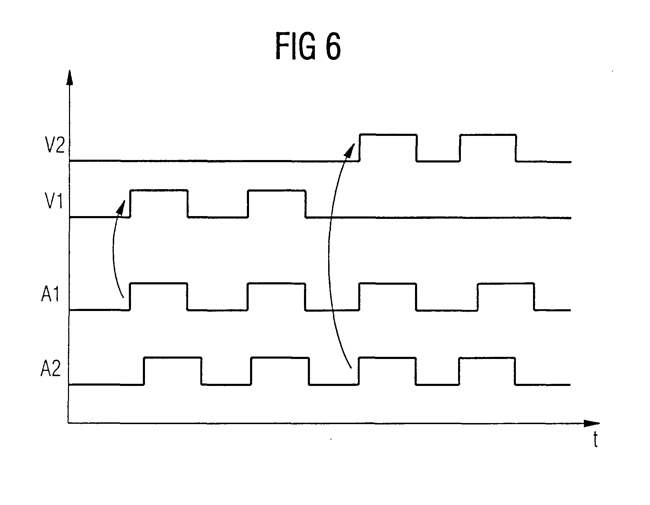

In Figur 5 ist eine weitere Ausführungsform der Vergleichsschaltung 3 dargestellt. Diese ist beispielsweise mit Standard TTL-Gattern realisiert und im Vergleich zu Figur 4 um zusätzliche Gatter erweitert, die folgendes bewirken: Falls das Signal A2 eine steigende Schaltflanke aufweist, die vor einer steigenden Schaltflanke des Signals A1 auftritt, so wird mit dem Vergleichssignal V2 ein Signalpuls erzeugt, der mit der fallenden Flanke des Signals A2 wieder abgeschaltet wird. Bei periodischen Signalen A1 und A2 wird also für das schnellere Signal ein Vergleichssignal V1 oder V2 mit der gleichen Frequenz erzeugt. Diese Signalpulse kann man verwenden, um die zeitliche Steuerung der Kalibrierschaltung 2 stufenweise einzustellen. Beispielsweise werden sogenannte variable Delays inkrementiert oder dekrementiert, gesteuert durch jeweils einen Signalimpuls der Signale V1 bzw. V2.

In Figur 6 ist eine schematische Darstellung von Signalen gemäß der Ausführungsform nach Figur 5 gezeigt. In diesem Beispiel weist das Signal A1 steigende Schaltflanken auf, die zunächst vor den steigenden Schaltflanken des Signals A2 auftreten. Dadurch wird ein Vergleichssignal V1 erzeugt, das im aktiven Zustand die Frequenz des Ausgangssignals A1 aufweist, dessen Schaltflanken zeitlich vor den entsprechenden Schaltflanken des Ausgangssignals A2 liegen. Sobald die Schaltflanken des Signals A2 vor den entsprechenden Schaltflanken des Signals A1 liegen, wird ein entsprechendes aktives Vergleichssignal V2 erzeugt, das die Frequenz des Signals A2 aufweist. In diesem Beispiel wurde also ein variables Delay für das Signal A1 so lange erhöht, bis die Schaltflanken des Signals A2 vor den entsprechenden Schaltflanken des Signals A1 liegen. Der Umschaltzeitpunkt zwischen dem aktiven Signal V1 und dem aktiven Signal V2 kann zur Erkennung des richtigen Kalibrierwerts genutzt werden.

Aufgrund von statistischen Effekten (z.B. infolge von Signalunschärfen) treten üblicherweise um den Umschaltpunkt herum zeitliche Bereiche auf (sogenannte Jitter), in denen periodische Vergleichssignale V1 und V2 mit gleicher Häufigkeit auftreten. Das Puls-Verhältnis der beiden Vergleichssignale V1 und V2 kann in diesem Unschärfebereich über eine geeignete Schaltung 7, wie z.B. einer Filterschaltung und/oder einer Integratorschaltung, gemessen werden. Damit kann der Kalibrierwert bzw. der Steuerwert R sehr exakt bestimmt werden.

In Figur 3 ist eine weitere Ausführungsform der erfindungsgemäßen Schaltungsanordnung dargestellt. Diese weist am Anschluß für das Vergleichssignal V der Vergleichsschaltung 3, das hier auf die Vergleichssignale V1 bzw. V2 erweitert ist, die erwähnte Schaltung 7 in Form einer Filterschaltung und/oder einer Integratorschaltung auf. Die Kalibrierschaltung 2 weist in diesem Beispiel zwei Verzögerungsschaltungen 5 und 6 auf, deren Eingänge jeweils mit einem der Anschlüsse 11 bzw. 12 der Schaltungsanordnung 1 verbunden sind. Die Ausgänge der Verzögerungsschaltungen 5 und 6 sind mit einem der Ausgänge 13 bzw. 14 verbunden. Über die Verzögerungsschaltungen 5 und 6 kann jeweils eine Verzögerung einer Schaltflanke der jeweiligen Eingangssignale E1 bzw. E2 eingestellt werden. Der jeweilige Kalibrierwert bzw. Steuerwert R ist jeweils getrennt für die Verzögerungsschaltung 5 und 6 in den Speicherschaltungen 41 bzw. 42 gespeichert.

Die Verzögerungsschaltungen 5 und 6 weisen hier digital einstellbare Verzögerungsglieder auf. Das heißt, in der jeweiligen Verzögerungsschaltung 5 bzw. 6 kann ein jeweiliges Delay variabel eingestellt werden. Alternativ dazu kann das variable Delay eines der Eingangssignale E1 oder E2 auch durch ein festgelegtes Delay ersetzt werden. Wenn z.B. der Verzögerungsbereich einer der Verzögerungsschaltungen 0 bis 1000 Pikosekunden beträgt, kann das Delay eines Referenzsignales beispielsweise fest auf 500 Pikosekunden eingestellt werden. Die jeweils andere Verzögerungsschaltung kann dann variabel relativ dazu in einem Bereich von ± 500 Pikosekunden eingestellt werden.

Die einzelnen Stufen einer variablen Verzögerungsschaltung müssen nicht streng linear sein, da sich die Kalibrierschaltung, beispielsweise in einem Testbetrieb, iterativ dem korrekten Steuerwert annähert. Es muß jedoch sichergestellt werden, daß sich die jeweilige Verzögerung kontinuierlich ändern läßt.

Die jeweiligen Steuerwerte sind beispielsweise in Registern mit mehreren Registerbits gespeichert. Bei einem Regelungsbereich von 1000 Pikosekunden und einer Auflösung von 1 Pikosekunde sind dazu in etwa 10 Registerbits erforderlich.

Um steigende Schaltflanken und fallende Schaltflanken gleichermaßen kalibrieren zu können, sind die Kalibrierschaltung 2 und die Anschlüsse 11 und 12 jeweils über eine Inverterschaltung I1 bzw. I2 miteinander koppelbar. Mit einem Umschalter können beide Schaltflanken unabhängig voneinander kalibriert werden. Die dazu notwendigen Steuerwerte können sich dabei unterscheiden. In diesem Fall weist die Kalibrierschaltung 2 insgesamt so viele Speicherschaltungen auf, daß jeweils die Steuerwerte für die steigenden Schaltflanken und fallenden Schaltflanken gespeichert werden können.

## Patentansprüche

1. Schaltungsanordnung zum Empfang von wenigstens zwei digitalen Signalen
- mit einer Kalibrierschaltung (2), die mit Anschlüssen (11, 12) für wenigstens zwei digitale Signale (E1, E2) verbunden ist und die Ausgänge (13, 14) für wenigstens zwei digitale Ausgangssignale (A1, A2) aufweist, die jeweils aus einem der digitalen Signale (E1, E2) abgeleitet sind,
- bei der durch die Kalibrierschaltung (2) eine zeitliche Steuerung einer Schaltflanke eines der Ausgangssignale (A1, A2) anhand eines Steuerwertes (R) erfolgt,
- mit einer Vergleichsschaltung (3), die mit den Ausgängen (13, 14) verbunden ist und die einen Anschluß für ein Vergleichssignal (V) aufweist, das anzeigt, daß eines der Ausgangssignale (A1, A2) relativ zum anderen Ausgangssignal zuerst eine Schaltflanke aufweist,
- bei der die Kalibrierschaltung (2) eine Speicherschaltung (4) enthält zur Speicherung des Steuerwertes (R),
- bei der die Kalibrierschaltung (2) einen Steuereingang (21) aufweist, über den der Steuerwert (R) anhand des Zustands des Vergleichssignals (V) der Vergleichsschaltung (3) einstellbar ist.

2. Schaltungsanordnung nach Anspruch 1,
**dadurch gekennzeichnet, daß**
der Anschluß für das Vergleichssignal (V) der Vergleichsschaltung (3) mit dem Steuereingang (21) der Kalibrierschaltung (2) verbunden ist.

3. Schaltungsanordnung nach einem der Ansprüche 1 oder 2,
**dadurch gekennzeichnet, daß**
- das Vergleichssignal (V) mit einem aktiven Zustand anzeigt, daß eines der Ausgangssignale (A1, A2) relativ zum anderen Ausgangssignal zuerst eine Schaltflanke aufweist, und
- die Vergleichsschaltung (3) derart ausgeführt ist, daß das Vergleichssignal (V) im aktiven Zustand einen periodischen Verlauf aufweist.

4. Schaltungsanordnung nach Anspruch 3,
**dadurch gekennzeichnet, daß**
- die Ausgangssignale (A1, A2) einen periodischen Verlauf aufweisen und
- das Vergleichssignal (V1, V2) der Vergleichsschaltung (3) im aktiven Zustand die Frequenz desjenigen Ausgangssignals aufweist, dessen Schaltflanken zeitlich vor den entsprechenden Schaltflanken des anderen Ausgangssignals liegen.

5. Schaltungsanordnung nach einem der Ansprüche 1 bis 4,
**dadurch gekennzeichnet, daß**
die Vergleichsschaltung (3) eine bistabile Kippstufe aufweist.

6. Schaltungsanordnung nach einem der Ansprüche 1 bis 5,
**dadurch gekennzeichnet, daß**
dem Anschluß für das Vergleichssignal (V1, V2) der Vergleichsschaltung (3) eine Filterschaltung und/oder eine Integratorschaltung (7) nachgeschaltet ist.

7. Schaltungsanordnung nach einem der Ansprüche 1 bis 6,
**dadurch gekennzeichnet, daß**
- die Kalibrierschaltung (2) eine Verzögerungsschaltung (5, 6) enthält, die einen Eingang aufweist, der mit einem der Anschlüsse (11, 12) für die digitalen Signale (E1, E2) verbunden ist zur Einstellung einer Verzögerung einer Schaltflanke eines der digitalen Signale (E1, E2) und
- ein Ausgang der Verzögerungsschaltung (5, 6) mit einem der Ausgänge (13, 14) der Kalibrierschaltung (2) verbunden ist.

8. Schaltungsanordnung nach Anspruch 7,
**dadurch gekennzeichnet, daß**
die Verzögerungsschaltung (5, 6) digital einstellbare Verzögerungsglieder enthält.

9. Schaltungsanordnung nach Anspruch 7 oder 8,
**dadurch gekennzeichnet, daß**
die Verzögerungsschaltung (5, 6) analog einstellbare Verzögerungsglieder enthält.

10. Schaltungsanordnung nach einem der Ansprüche 1 bis 9,
**dadurch gekennzeichnet, daß**
die Kalibrierschaltung (2) und die Anschlüsse (11, 12) für die digitalen Signale (E1, E2) jeweils über eine Inverterschaltung (I1, I2) miteinander koppelbar sind.

11. Schaltungsanordnung nach einem der Ansprüche 1 bis 10,
**dadurch gekennzeichnet, daß**
die Schaltungsanordnung (1) in einem Meßgerät oder einem Testgerät enthalten ist.
